Europäisches Patentamt

European Patent Office

Office européen des brevets

(11) Veröffentlichungsnummer: **0 044 046**

**A1**

(12) ## EUROPÄISCHE PATENTANMELDUNG

(21) Anmeldenummer: 81105359.4

(22) Anmeldetag: 09.07.81

(51) Int. Cl.³: **G 05 F 3/20**

(30) Priorität: 16.07.80 DE 3026961

(43) Veröffentlichungstag der Anmeldung:
20.01.82 Patentblatt 82/3

(84) Benannte Vertragsstaaten:
DE FR GB

(71) Anmelder: SIEMENS AKTIENGESELLSCHAFT Berlin
und München
Postfach 22 02 61
D-8000 München 22(DE)

(72) Erfinder: Seher, Eugen
Sindelfinger Weg 9
D-7031 Grafenau 1(DE)

(54) **Monolithisch integrierte MIS-Halbleiterschaltung.**

(57) Die Erfindung betrifft eine monolithisch integrierte MIS-Halbleiterschaltung mit einem Substratvorspannungsgenerator, insbesondere einem dynamischen RAM-Speicher. Das Ziel der Erfindung ist dabei, Schwankungen der effektiven Substratvorspannung, die vom Substratvorspannungsgenerator nicht unmittelbar ausgeglichen werden können, zu unterbinden. Ursache für solche Schwankungen sind z.B. durch die Auf- und Entladung von in Form von Diffusionsgebieten vorliegenden Adressierleitungen bei dynamischen RAM-Speichern. Gemäß der Erfindung wird die Verwendung einer Kompensationskapazität vorgeschlagen, deren einer Pol mit dem Substrat der Halbleiterschaltung verbunden bzw. mit diesem identisch ist. Der Ladezustand dieser Kompensationskapazität wird jeweils in entgegengesetzter Richtung wie der resultierende Ladezustand der die Substratvorspannung beeinflussenden Kapazität der MIS-Halbleiterschaltung gesteuert.

FIG 1

0044046

Siemens Aktiengesellschaft
Berlin und München

Unser Zeichen
VPA
80 P 1 1 0 5 E

### Monolithisch integrierte MIS-Halbleiterschaltung

Die vorliegende Erfindung betrifft eine monolithisch integrierte MIS-Halbleiterschaltung mit einem Substratvorspannungsgenerator, insbesondere dynamische Schreib-Lese-Speicher.

Aus den beiden Literaturstellen "Electronics" (Sept. 16, 1976), S. 42/43, und "1976 IEEE International Solid-State Circuits Conference", S. 56/57, ist es bekannt, monolithisch integrierte MIS-Halbleiterschaltungen mit einem sog. Substratvorspannungsgenerator zu versehen, welcher die Aufgabe hat, die Konstanz der Schwellenspannung für die an der Schaltung beteiligten MIS-Feldeffekttransistoren zu verbessern. Die dort beschriebenen Substratvorspannungsgeneratoren sorgen dafür, daß das Potential des an die eigentliche integrierte Schaltung angrenzenden bzw. diese aufnehmenden Substratbereichs in dem die Schaltung enthaltenden Siliciumplättchen auf einem möglichst konstanten Wert oberhalb (oder unterhalb) des Bezugspotentials, z.B. $V_{SS}$, zu halten. Der Grund für diese Maßnahme ist aus dem genannten Stand der Technik ersichtlich.

Bei dynamischen Halbleiterschaltungen, insbesondere dynamischen Schreib-Lese-Speichern, also RAM-Speichern, hat sich jedoch gezeigt, daß man mit normal ausgebildeten Substratvorspannungsgeneratoren nicht alle Schwankungen des Ladezustands des Substrats kompensieren kann. Man kann nun, wie z.B. in der DE-Patentanmeldung P 28 12 378.6 (VPA 78 P 1043) beschrieben, den Substratvorspannungsgenerator über eine Regelschaltung steuern, um beim Auftreten von starken Schwankungen im Ladezustand des Substrats eine ausreichende Kompensation zu haben. Mitunter wäre jedoch eine andere Möglichkeit erwünscht, die zur Unterstützung eines geregelten Substratvorspannungsgenerators oder für sich allein mit Erfolg eingesetzt werden
kann.

Aufgabe der Erfindung ist es, eine solche Möglichkeit anzugeben.

Hierzu ist erfindungsgemäß die Anwesenheit einer zusätzlichen und der Kompensation des Einflusses der in der Schaltung vorgesehenen Betriebskapazitäten und parasitären Kapazitäten auf die Substratvorspannung dienenden Kapazität
vorgesehen, deren einer Pol durch das Substrat gebildet
ist bzw. mit diesem in unmittelbarer leitender Verbindung
steht, und deren Ladungszustand jeweils in entgegengesetzter Richtung wie der resultierende Ladungszustand der in
der Schaltung vorgesehenen Kapazität bzw. Kapazitäten gesteuert ist.

Die von der Erfindung vorgeschlagene Möglichkeit ist besonders für den im folgenden zu beschreibenden Fall geeignet.

Erfahrungsgemäß sind die Ausgänge der üblichen Vorspannungsgeneratoren so hochohmig, daß beim raschen Umladen
von in der Schaltung anwesenden Kapazitäten, deren einer
Pol vom Substrat gebildet ist, es zu beträchtlichen Schwankungen der effektiven Substratvorspannung kommen kann, die
vom Substratvorspannungsgenerator nicht unmittelbar ausgeglichen werden können. Dieser Fall tritt insbesondere bei
dynamischen RAM's auf und ist durch das Umladen größerer
an das Substrat unmittelbar angrenzender Diffusionsgebiete bedingt. Solche Diffusionsgebiete können z.B. durch die
Bitleitungen eines solchen Speichers gegeben sein. Beim gemeinsamen Aufladen und Entladen einer großen Anzahl solcher Bitleitungen werden kapazitiv Ladungen in das Substrat
eingekoppelt, die erfahrungsgemäß vom Substratvorspannungsgenerator nicht sofort kompensiert werden können.

Durch die Erfindung wird nun durch die zweite, der Kompensation des Einflusses dieser Ladung dienenden Kapazität diese Ladung automatisch kompensiert. Diese Kompensationskapazität ist zweckmäßig in ähnlicher Weise wie die bezüglich ihres Einflusses auf das Substrat zu kompensierende Betriebskapazität zu realisieren, da ein solches Vorgehen keine zusätzlichen Arbeitsschritte erfordert. Falls man aus bestimmten Gründen, z.B. im Interesse der Platzersparnis, von einem solchen Vorgehen abgehen möchte und z.B. die Kompensationskapazität als MOS-Kapazität ausgestalten möchte, so kann dies ohne weiteres geschehen. Man muß dabei lediglich darauf achten, daß der eine Beleg der MOS-Kapazität (ebenso wie im Falle der Realisierung durch eine Sperrschichtkapazität) als einen Pol das Substrat hat.

Die Erfindung wird nun anhand der Figuren 1 bis 5 näher beschrieben. Dabei stellt Fig. 1 ein Prinzip-Schaltbild, Fig. 2 das zugehörige Phasendiagramm, Fig. 3 ein bevorzugtes Anwendungsbeispiel der Erfindung, Fig. 4 das zu diesem Ausführungsbeispiel gehörende Phasendiagramm und Fig. 5 ein Beispiel für die halbleitertechnische Realsierung dar.

Die ideale Kompensation der oben beschriebenen ungünstigen Wirkung der in der Schaltung enthaltenen Kapazitäten auf die Stabilität der Substratvorspannung und damit des Substratvorspannungspotentials $V_{BB}$ ist ersichtlich dann gegeben, wenn zu jedem Zeitpunkt die Bedingung

$$C_1 \frac{dU_1}{dt} + C_2 \frac{dU_2}{dt} = 0$$

erfüllt ist, wobei $C_1$ die störend auf die Substratvorspannung $V_{BB}$ einwirkende Kapazität aus der eigentlichen Schaltung und $C_2$ die Kompensationskapazität gemäß der Erfindung ist. $dU_1/dt$ ist die zeitliche Ableitung der das Substratpotential $V_{BB}$ störend beeinflussenden Spannung aus dem Bereich der eigentlichen Schaltung und $dU_2/dt$ die zeitliche Ableitung der die Kompensationskapazität $C_2$ beaufschlagenden Kompensationsspannung ist.

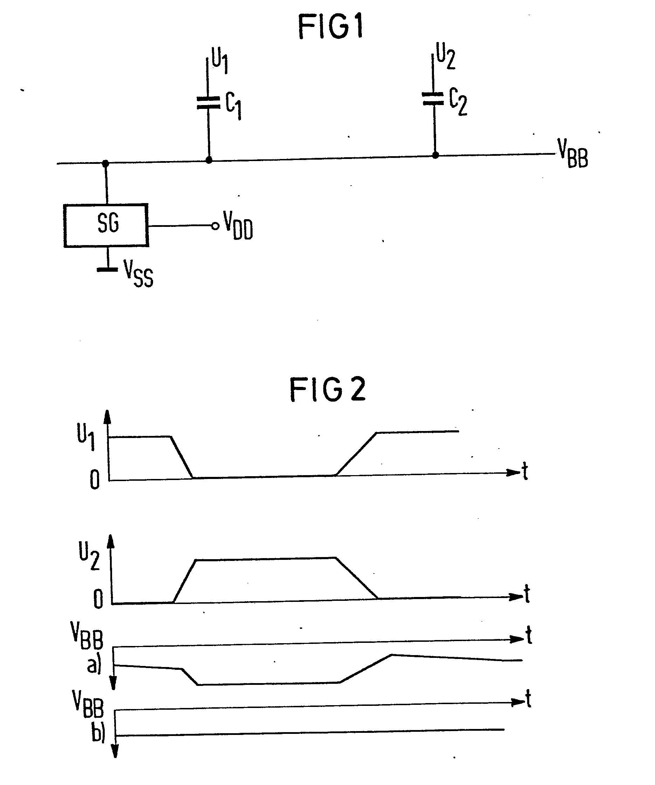

Bei dem in Fig. 2 dargestellten Blockschaltbild liefert der Substratvorspannungsgenerator SG, der seinerseits durch ein erstes Betriebspotential, z.B. $V_{DD}$, und ein zweites Betriebspotential, z.B. das Bezugspotential $V_{SS}$, versorgt ist, ein Zwischenpotential $V_{BB}$, das zusammen mit dem Bezugspotential die Substratvorspannung bildet. Dieses Substratvorspannungspotential $V_{BB}$ liegt aufgrund der Definition der Erfindung stets am Substrat und somit an dem einen Pol der störenden Kapazität $C_1$ und außerdem an dem einen Pol der Kompensationskapazität $C_2$. Der andere Pol der Störkapazität $C_1$ wird durch ein schaltungsinternes Signalpotential $U_1$ und der andere Pol der Kompensationskapazität $C_2$ durch ein Kompensationspotential $U_2$ beaufschlagt. Beide Potentiale $U_1$ und $U_2$ sind zeitabhängig. Die Störkapazität $C_1$ bildet einen Bestandteil der eigentlichen MIS-Schaltung, insbesondere MOS-Schaltung, während die Kompensationskapazität die gemäß der Erfindung vorgeschlagene Ergänzung der Schaltung bildet.

Das Verhalten des die Substratvorspannung $V_{BB}$ nachteilig beeinflussenden Störpotentials $U_1$ ist in Abhängigkeit von der Zeit t im ersten Diagramm von Fig. 2 als Beispiel dargestellt. Das dazugehörige zeitliche Verhalten des Kompensationspotentials $U_2$ ist aus dem zweiten Diagramm von Fig. 2 ersichtlich. Bei Abwesenheit des Kompensationskondensators $C_2$ und dessen Beaufschlagung entsprechend Fig. 2, Diagramm 2, hätte man das aus dem dritten Diagramm von Fig. 2 ersichtliche, unerwünschte Verhalten des Substratpotentials $V_{BB}$, während dank der von der Erfindung vorgeschlagenen Maßnahme die aus dem vierten Diagramm von Fig. 2 ersichtliche Konstanz des Substratpotentials $V_{BB}$ auch dann in ausreichendem Maße gesichert ist, wenn ein ungeregelter Substratvorspannungsgenerator SG verwendet ist.

0044046

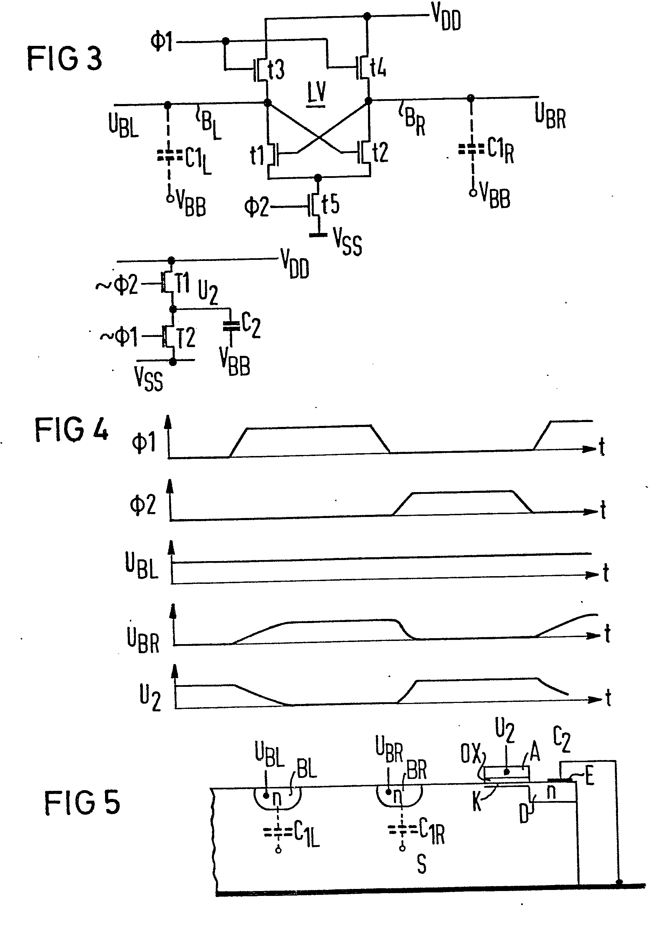

Als ein Anwendungsbeispiel der Erfindung kann z.B. deren Einsatz in einen einen dynamischen 64 K-RAM-Speicher aufnehmenden Siliciumchip betrachtet werden. Die Fig. 3 zeigt den in üblicher Weise ausgestalteteten und je einer Matrixzeile des Speichers zugeordneten Leseverstärker (Sense Amplifier) LV eines solchen Schreib-Lesespeichers.und dessen Verbindung über zwei Bitleitungen BL und BR mit mit weiteren (nicht dargestellten) Schaltungsteilen des Speichers. Also solche Schaltungsteile sind einmal die als Ein-Transistor-Speicherzellen ausgebildeten Speicherzellen der betreffenden Matrixzeile als auch periphere Schaltungsteile zu nennen. Die Schaltung ist im Beispielsfall in n-Kanal-MOS-Technik ausgebildet.

Dabei ist der Leseverstärker durch das erste Betriebspotential $V_{DD}$ und das zweite - als Bezugspotential (Masse) dienende - Betriebspotential $V_{SS}$ versorgt. Der Kern des Leseverstärkers besteht aus den beiden kreuzgekoppelten n-Kanal-MOS-Feldeffekttransistoren $t_1$ und $t_2$ (beide vom Anreicherungstyp), deren Source-Anschlüsse gemeinsam über einen vom Takt $\phi_2$ gesteuerten weiteren - gleichen - Transistor $t_5$ an Masse und deren Drain-Anschlüsse über je einen vom gemeinsamen Takt $\phi_1$ gesteuerten vierten bzw. fünften Transistor $t_3$ bzw. $t_4$ vom Typ der bereis genannten Transistoren $t_1$, $t_2$ und $t_5$ an das erste Betriebspotential $V_{DD}$ anschaltbar sind. Die störende Bitleitungs-Kapazität $C_1$ ist in diesem Falle durch die beiden Teilkapazitäten $C1_L$ und $C1_R$ gegeben, die als parasitäre Kapazitäten der als Diffusionszonen an der Oberfläche des Substrats erzeugten und deshalb durch je einen (in Sperrichtung gepolten) pn-Übergang gegen das den entgegengesetzten Leitungstyp aufweisende Substrat (vgl. Fig. 5) abgegrenzten Bitleitungen $B_L$ und $B_R$ bedingt sind. Die linke Bitleitung $B_L$ ist durch das Potential $U_{BL}$ und die rechte Bitleitung $B_R$ durch das Potential $U_{BR}$ aufgrund des Speicherbetriebs beaufschlagt.

Entsprechend der Erfindung ist nun eine aus der Kompensationskapazität $C_2$ und zwei MOS-Feldeffekttransistoren $T_1$ und $T_2$ vom Typ der bereits genannten Transistoren $t_1$ bis $t_4$ bestehende und mit der übrigen Schaltung monolithisch zusammengefaßte Ergänzung vorgesehen. Die beiden Transistoren $T_1$ und $T_2$ sind mit ihren Source-Drainstrecken hintereinander geschaltet, wobei der Drain des Transistors $T_1$ mit dem ersten Betriebspotential $V_{DD}$ und die Source des anderen Transistors $T_2$ mit dem zweiten Betriebspotential $V_{SS}$ verbunden ist. Dabei ist das Gate des am Bezugspotential $V_{SS}$ liegenden Transistors $T_2$ durch die Taktimpulse $\phi_1$ beaufschlagt, die zugleich die bereits oben dargestellte Aufgabe haben, den Leseverstärker LV über die beiden Transistoren $t_3$ und $t_4$ an das erste Betriebspotential $V_{DD}$ anzuschalten. Andererseits dienen die die Anschaltung des Leseverstärkers LV über den Transistor $t_3$ an das Bezugspotential $V_{SS}$ schaltenden Taktimpulse $\phi_2$ zur Steuerung des Gates des mit seinem Drain am ersten Betriebspotential $V_{DD}$ liegenden Transistors $T_1$ in der Ergänzungsschaltung. Die Kompensationskapazität $C_2$ ist mit ihrem einen - mit dem Substrat der Schaltung leitend verbundenen oder unmittelbar durch das Substrat gegebenen - Pol durch das Substratvorspannungspotential $V_{BB}$ und mit ihrem anderen Pol durch einen Schaltungspunkt zwischen den beiden Transistoren $T_1$ und $T_2$ der Ergänzungsschaltung beaufschlagt. Durch die beiden Transistoren $T_1$ und $T_2$ wird somit die Kompensationskapazität $C_2$ gegensinnig zu der jeweiligen Beaufschlagung der Störkapazität $C1_L$ bzw. $C1_R$ aufgeladen.

Dem dynamischen Betrieb entspricht es, daß die Impulse des Takts $\phi_1$ jeweils in den Pausen zwischen den einzelnen Impulsen des Taktes $\phi_2$ erscheinen, wie dies aus den beiden ersten Diagrammen von Fig. 4 ersichtlich ist. Das dritte Diagramm in Fig. 4 zeigt das Verhalten des Potentials $U_{BR}$ an der Bitleitung $B_R$ und das vierte Diagramm das Verhalten des Potentials $U_{BL}$ an der Bitleitung $B_L$. Das angestreb-und aufgrund der aus Fig. 3 ersichtlichen Ergänzung gemäß der Erfindung erreichte Verhalten dern Kompensationsspannung $U_2$ ist im letzten Diagramm der Fig. 4 gezeigt. Da zur Versorgung der übrigen Schaltung und damit der Bitleitungen $B_L$ und $B_R$ ebenfalls die beiden Betriebspotentiale $V_{DD}$ und $V_{SS}$ zuständig sind, bewirkt das aus Fig. 4 ersichtliche zeitliche Verhalten des Kompensationspotentials $U_2$ auf jeden Fall das angestrebte und aus Fig. 2 ersichtliche zeitliche Verhalten der zwischen dem Substrat und Masse, also dem Bezugspotential $V_{SS}$, liegenden Substratvorspannung $V_{BB}$.

Die aus Fig. 5 ersichtliche Darstellung der Komepnsationskapazität $C_2$ enthält eine - gleichzeitig mit den Bitleitungen $B_L$ und $B_R$ als Diffusionsgebiete vom n-Typ im p-dotierten Substrat S erzeugte Diffusionszone D, die über eine sperrfreie Elektrode E leitend mit dem Substrat S verbunden ist. Sie stellt somit den einen Pol des Kompensationskondensators $C_2$ dar, der allerdings noch durch eine induzierte Kanalzone K an der Oberfläche des Substrats S vergrößert ist. Eine vorzugsweise aus polykristallinem, dotiertem Silicium im Beispielsfall (allgemein aus dem Material der Gate-Elektroden der Transistoren der Schaltung) bestehender zweiter Anschluß A ist von dem durch ihn induzierten Kanal K durch eine dünne $SiO_2$-Schicht OX getrennt. Der leitende Kanal K ist in der bei Anreicherungstyp-MOS-FET's üblichen Weise erzeugt, so daß der Kompensationskondensator $C_2$ durch einen MOS-Kondensator mit einer Erweiterung durch das Diffusionsgebiet D gegeben ist. Der Anschluß A des Kompensationskondensators $C_2$ liegt an dem Kompensationspotential $U_2$, also an einem Schaltungspunkt zwischen den beiden Transistoren $T_1$ und $T_2$ ersichtlichen Ergänzungsschaltung.

Man kann nun jedem zusammengehörigen Bitleitungspaar $B_L$ und $B_R$ je einen solchen Kompensationskondensator $C_2$

zuordnen und dessen Kapazität auf die Kapazität der durch die Bitleitung $B_L$ bzw. $B_R$ bedingten Störkapazität abstimmen. Wenn aber infolge des Betriebs des Speichers jeweils nur die Hälfte der insgesamt vorgesehenen Bitleitungen in je einer Betriebsphase Einfluß auf das Substratpotential nimmt, so empfiehlt es sich lediglich eine einzige · entsprechend vergrößerte Kompensationskapazität für die Gesamtheit der Bitleitungen vorzusehen.

Die Erfindung läßt sich auch bei anderen MIS-Halbleiterschaltungen mit Erfolg einsetzen, deren Substratvorspannung durch einen Substratvorspannungsgenerator geliefert wird, wobei die Anwendung nicht nur auf Speicherschaltungen beschränkt ist. Dabei kann es sich auch darum handeln, störende Einflüsse anderer Kapazitäten, als sie durch die Anwendung von als Diffusionszonen im Substrat ausgebildete Bitleitungen bedingt sind, auf das vom Substratvorspannungsgenerator gelieferte Substratpotential $V_{BB}$ auszuschalten.

Die in Fig. 3 dargestellte Ergänzungsschaltung empfiehlt sich vor allem bei Speichern der beschriebenen Art. Man hat ersichtlich aber auch die Möglichkeit, die zur Aufladung der Störkapazitäten führenden Betriebssignale auf andere Weise dazu zu benutzen, um die Ladeverhältnisse der Kompensationskapazität bzw. Kompensationskapazitäten im Sinne der Erfindung zu steuern.

5 Figuren

7 Patentansprüche

Patentansprüche

1.) Monolithisch integrierte MIS-Halbleiterschaltung mit einem Substratvospannungsgenerator, gekennzeichnet durch die Anwesenheit einer zusätzlichen und der Kompensation des Einflusses der in der Schaltung vorgesehenen Betriebskapazitäten bzw. vorhandenen parasitären Kapazitäten ($C_1$) auf die Substratvorspannung ($V_{BB}$) dienenden Kapazität ($C_2$), deren einer Pol durch das Substrat (S) gebildet ist bzw. mit diesem in unmittelbarer leitender Verbindung steht und deren Ladezustand jeweils in entgegengesetzter Richtung wie der resultierende Ladezustand der die Substratvorspannung ($V_{BB}$) beeinflussenden Kapazität ($C_1$) gesteuert ist.

2.) MIS-Halbleiterschaltung nach Anspruch 1, dadurch gekennzeichnet, daß die Steuerung des Ladezustands der Kompensationskapazität ($C_2$) derart erfolgt, daß die Bedingung

$$C_1 \frac{dU_1}{dt} + C_2 \frac{dU_2}{dT} = 0$$

beständig erfüllt ist, wobei $C_1$ der Kapazitätswert der das Substratpotential in unerwünschter Weise beeinflussenden Kapazität ($C_1$) in der eigentlichen Schaltung, $U_1$ die die Aufladung dieser Störkapazität $C_1$ beeinflussende Spannung, $C_2$ der Kapazitätswert der Kompensationskapazität ($C_2$) und $U_2$ die zur Ladung der Kompensationskapazität ($C_2$) vorgesehene Spannung ist.

3.) Halbleiterschaltung nach Anspruch 1 oder 2, dadurch gekennzeichnet, daß die Halbleiterschaltung als dynamischer RAM-Speicher ausgebildet ist.

4.) Halbleiterschaltung nach Anspruch 3, dadurch gekennzeichnet, daß die einerseits durch ein erstes Betriebspotential ($V_{DD}$) und andererseits durch ein zweites Betriebspotential ($V_{SS}$) und den einzelnen Zeilen der Spei-

0044046

cher Matrix zugeordneten Leseverstärker (LV) durch eine erste Folge ($\phi_1$) von Taktimpulsen an das erste Betriebspotential ($V_{DD}$) und durch eine zweite Folge ($\phi_2$) von Taktimpulsen an das zweite Betriebspotential ($V_{SS}$) angeschaltet ist und dabei die Beaufschlagung durch die beiden Betriebspotentiale abwechselnd erfolgt, daß wenigstens eine aus zwei hintereinander geschalteten MIS-Feldeffekttransistoren ($T_1, T_2$) bestehende Transistorkombination derart vorgesehen ist, daß der Drain des einen Transistors ($T_1$) vom ersten Betriebspotential ($V_{DD}$) und sein Gate durch die zweite Folge von Taktimpulsen ($\phi_2$) gesteuert ist, während die Source des anderen Transistors ($T_2$) am zweiten Betriebspotential ($V_{SS}$) und sein Gate an der ersten Folge von Taktimpulsen ($\phi_1$) liegt, und daß schließlich der andere Pol der Kompensationskapazität ($C_2$) leitend mit einem zwischen den beiden Transistoren ($T_1$, $T_2$) liegenden Schaltungspunkt verbunden ist.

5.) Halbleiterschaltung nach einem der Ansprüche 1 bis 4, dadurch gekennzeichnet, daß die Kompensationskapazität ($C_2$) durch einen zwischen dem Substrat (S) und einer zu diesem entgegengesetzt dotierten Halbleiterzone liegenden pn-Übergang gegeben ist.

6.) Halbleiterschaltung nach einem der Ansprüche 1 bis 5, dadurch gekennzeichnet, daß die Kompensationskapazität ($C_2$) durch einen MIS-Kondensator gegeben ist.

7.) Halbleiterschaltung nach Anspruch 6, dadurch gekennzeichnet, daß in das Substrat(S) eine Zone (D) des entgegengesetzten Leitungstyps eingelassen und über eine Elektrode (E) sperrfrei kontaktiert und diese Elektrode (E) leitend mit dem Substrat (S) verbunden ist, daß außerdem ein MOS-Kondensator ($C_2$) an einem durch das Substrat (S) eingenommenen Oberflächenteil des die Halbleiterschaltung enthaltenden Chips derart vorgesehen ist, daß der leitende Kanal (K) des Kondensators ($C_2$) mit der eingelassenen Zone (D) unmittelbar verbunden ist.

FIG 1

FIG 2

FIG 3

FIG 4

FIG 5

Europäisches Patentamt

**EUROPÄISCHER RECHERCHENBERICHT**

**0044046**

Nummer der Anmeldung

EP 81 10 5359

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | IBM TECHNICAL DISCLOSURE BULLETIN, Band 17, Nr. 5, Oktober 1974, Seite 1369 New York, U.S.A. G. SONODA: "Active decoupling circuit"  * Insgesamt * | 1-5 |
| A | IBM TECHNICAL DISCLOSURE BULLETIN, Band 11, Nr. 10, März 1969, Seite 1219 New York, U.S.A. H. FRANTZ et al.: "Mosfet substrate bias-voltage generator"  * Figuren * | 1 |
| A | IBM TECHNICAL DISCLOSURE BULLETIN, Band 20, Nr. 11A, April 1978, Seiten 4297,4298 New York, U.S.A. R.H. LINTON: "Technique for optimizing signals in dynamic memory systems"  * Insgesamt * | 1 |

**KLASSIFIKATION DER ANMELDUNG (Int. Cl.³)**

G 05 F 3/20

**RECHERCHIERTE SACHGEBIETE (Int. Cl.³)**

G 05 F  3/20
G 11 C 11/24
     11/40

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 21-09-1981 | ZAEGEL |

EPA form 1503.1  06.78